# EUROPÄISCHE PATENTANMELDUNG

(11) **EP 3 872 452 A1**
(43) Veröffentlichungstag der Anmeldung: **01.09.2021**
(21) Anmeldenummer: 20159822.4
(22) Anmeldetag: 27.02.2020
(51) Int. Cl.: G01C 15/00, G06N 20/00

(54) **VERFAHREN ZUM BESTIMMEN EINER POSITION UND/ODER ORIENTIERUNG EINES MESSGERÄTES**

(71) Anmelder: Hilti Aktiengesellschaft, 9494 Schaan (LI)
(72) Erfinder: Gloor, Thomas, 9495 Triesen (LI); Arth, Clemens, 8111 Gratwein-Straßengel (AT); Stapleton, Mehdi, 8010 Graz (AT)
(74) Vertreter: Hilti Aktiengesellschaft Corporate Intellectual Property

(57) **Zusammenfassung**

Verfahren zum Bestimmen einer Position und/oder Orientierung eines Messgerätes in einer Messumgebung, die in einem Geometriemodell abgebildet ist, mittles eines trainierten künstlichen neuronalen Netzes, das mittels bekannter Messumgebungen dahingehend trainiert wurde, eine Prognose für die Notwendigkeit einer weiteren Messung durch das Messgerät und ggfs. eine Prognose für die Eignung einer Messposition des Messgerätes abzugeben.

## Beschreibung

### Technisches Gebiet

Die vorliegende Erfindung betrifft ein Verfahren zum Bestimmen einer Position und/oder Orientierung eines Messgerätes gemäß dem Oberbegriff des Anspruchs 1, ein Verfahren zum Präzisieren der Position und/oder Orientierung eines Messgerätes gemäß dem Oberbegriff des Anspruchs 9, eine Vorrichtung zum Bestimmen einer Position und/oder Orientierung eines Messgerätes gemäß dem Oberbegriff des Anspruchs 10 sowie ein Computerprogrammprodukt gemäß dem Oberbegriff des Anspruchs 11.

### Stand der Technik

Messgeräte, wie beispielsweise Totalstationen, verfügen über Winkel- und Distanzmesseinrichtungen und führen Winkel- und Distanzmessungen zu ausgewählten Zielobjekten aus. Die Winkel- und Distanzmesswerte werden im Bezugssystem des Messgerätes gemessen und müssen für eine absolute Positionsbestimmung noch mit einem äußeren Bezugssystem verknüpft werden.

Bei bekannten Verfahren zum Bestimmen einer Position und/oder Orientierung eines Messgerätes in einem äußeren Bezugssystem werden Zielobjekte an bekannten Kontrollpunkten positioniert und die Koordinaten der Kontrollpunkte werden im Bezugssystem des Messgerätes gemessen; die Koordinaten der Kontrollpunkte im äußeren Bezugssystem sind bekannt. Die Position und/oder Orientierung des Messgerätes wird mithilfe der Koordinaten der Kontrollpunkte im äußeren Bezugssystem und im Bezugssystem des Messgerätes bestimmt. Nachteilig ist, dass die Kontrollpunkte in der Messumgebung angebracht und vermessen werden müssen; das Vermessen der Kontrollpunkte erfordert einen erfahrenen Bediener und ist fehleranfällig.

### Darstellung der Erfindung

Die Aufgabe der vorliegenden Erfindung besteht darin, ein Verfahren zum Bestimmen einer Position und/oder Orientierung eines Messgerätes zu entwickeln, bei dem die Fehleranfälligkeit reduziert ist. Außerdem soll nach Möglichkeit die Genauigkeit, mit der die Position und/oder Orientierung des Messgerätes bestimmt wird, verbessert und/oder die dazu erforderliche Zeit reduziert werden.

Diese Aufgabe wird bei dem eingangs genannten Verfahren erfindungsgemäß durch die Merkmale des unabhängigen Anspruchs 1 gelöst. Vorteilhafte Weiterbildungen sind in den abhängigen Ansprüchen angegeben.

Das erfindungsgemäße Verfahren zum Bestimmen einer Position und/oder Orientierung eines Messgerätes in einer Messumgebung, die in einem Geometriemodell abgebildet ist, weist folgende Schritte auf:
▪ Bereitstellen eines trainierten künstlichen neuronalen Netzes, das mittels bekannter Messumgebungen dahingehend trainiert wurde, eine Prognose für die Notwendigkeit einer weiteren Messung durch das Messgerät und ggfs. für die Eignung einer Messposition des Messgerätes abzugeben,
▪ Festlegen einer Gruppe von Aktionen, die zumindest eine Aktion "Abbrechen", eine Aktion "Verstellen 1" und eine Aktion "Messen 1" umfasst, wobei die Aktion "Abbrechen" bedeutet, dass keine weitere Messung durch das Messgerät erforderlich ist, die Aktion "Verstellen 1" bedeutet, dass eine weitere Messung durch das Messgerät erforderlich ist und die aktuelle Messposition des Messgerätes als nicht geeignet bewertet wird, und die Aktion "Messen 1" bedeutet, dass eine weitere Messung durch das Messgerät erforderlich ist und die aktuelle Messposition des Messgerätes als geeignet bewertet wird,
▪ Initialisieren eines Wahrscheinlichkeitsrasters für die Position und/oder Orientierung des Messgerätes in der Messumgebung,
▪ Ausführen einer Folge von Schritten, wobei
   (1) in einem ersten Schritt der Folge die Notwendigkeit einer weiteren Messung durch das Messgerät und die Eignung der aktuellen Messposition des Messgerätes durch Anwendung des trainierten künstlichen neuronalen Netzes bewertet wird, wobei die Bewertung in Form eines Erfüllungsgrades für die Aktionen der Gruppe von Aktionen durchgeführt wird,
   (2) in einem zweiten Schritt der Folge diejenige Aktion, für die im ersten Schritt der beste Erfüllungsgrad bestimmt wurde, als beste Aktion ermittelt wird,
   (3) in einem dritten Schritt der Folge geprüft wird, ob die beste Aktion mit der Aktion "Abbrechen" übereinstimmt, wobei
      - für den Fall, dass die beste Aktion nicht mit der Aktion "Abbrechen" übereinstimmt, die Folge von Schritten fortgesetzt wird, und
      - für den Fall, dass die beste Aktion mit der Aktion "Abbrechen" übereinstimmt, die Folge von Schritten abgebrochen wird,
   (4) in einem vierten Schritt der Folge die beste Aktion ausgeführt wird, wobei
      - für den Fall, dass die Aktion "Verstellen 1" als beste Aktion ermittelt wurde, das Messgerät in einer neuen Messposition angeordnet wird und das Verfahren mit dem ersten Schritt der Folge fortgesetzt wird, und
      - für den Fall, dass die Aktion "Messen 1" als beste Aktion ermittelt wurde, in der aktuellen Messposition eine Messung mittels des Messgerätes durchgeführt wird, das Wahrscheinlichkeitsraster für die Position und/oder Orientierung des Messgerätes in der Messumgebung aktualisiert wird und das Verfahren mit dem ersten Schritt der Folge fortgesetzt wird,
▪ Fortsetzung des Verfahrens nach Abbruch der Folge im dritten Schritt mit der Berechnung der Position und/oder Orientierung des Messgerätes in der Messumgebung.

Die Idee der vorliegenden Erfindung besteht darin, die Position und/oder Orientierung eines Messgerätes in der Messumgebung mithilfe eines trainierten künstlichen neuronalen Netzes zu bestimmen. Das künstliche neuronale Netz wird im Vorfeld mittels bekannter Messumgebungen dahingehend trainiert, dass eine Prognose für die Notwendigkeit einer weiteren Messung durch das Messgerät und für die Eignung einer Messposition des Messgerätes abgeben kann. Jede Messumgebung, die zum Training des künstlichen neuronalen Netzes verwendet wird, ist durch ein Geometriemodell definiert und wird in mehreren Bildern abgebildet. Die Anwendung des trainierten künstlichen neuronalen Netzes ermöglicht es, die Qualität von Messpunkten der Messumgebung zu bewerten, um bei einer reduzierten Anzahl von Messungen durch das Messgerät eine hohe Genauigkeit für die Position und/oder Orientierung des Messgerätes im Bezugssystem der Messumgebung zu erzielen. Das erfindungsgemäße Verfahren ermöglicht die Auswahl von geeigneten Messpositionen, also Messpositionen, deren zugehörige Messwerte die Ungenauigkeit bei der Bestimmung der Position und/oder Orientierung des Messgerätes verringern. Der wesentliche Vorteil für den Anwender besteht darin, dass keine Kontrollpunkte in der Messumgebung angebracht werden müssen und das Vermessen der Kontrollpunkte entfällt. Das Messgerät kann in jeder Messumgebung eingesetzt werden, die in einem Geometriemodell abgebildet ist. Als Geometriemodell kann beispielsweise ein mit CAD-Unterstützung hergestelltes Konstruktionsmodell der Messumgebung verwendet werden oder die Messumgebung wird mittels eines Laserscanners abgescannt und aus den Scandaten wird ein Geometriemodell der Messumgebung erstellt.

Die Aktionen, die das Messgerät während des erfindungsgemäßen Verfahrens ausführen kann, sind in einer Gruppe von Aktionen festgelegt, die zumindest eine Aktion "Abbrechen", eine Aktion "Verstellen 1" und eine Aktion "Messen 1" umfasst. Die Aktion "Abbrechen" bedeutet, dass keine weitere Messung durch das Messgerät erforderlich ist, die vom Messgerät ermittelten Messwerte reichen aus, um die Position und/oder Orientierung des Messgerätes mit der geforderten Genauigkeit zu bestimmen. Die Aktion "Verstellen 1" bedeutet, dass eine weitere Messung durch das Messgerät erforderlich ist und die aktuelle Messposition des Messgerätes als nicht geeignet bewertet wird, wobei eine Messposition als nicht geeignet bewertet wird, wenn die Ungenauigkeit bei der Bestimmung der Position und/oder Orientierung des Messgerätes nicht verringert wird. Die Aktion "Messen 1" bedeutet, dass eine weitere Messung durch das Messgerät erforderlich ist und die aktuelle Messposition des Messgerätes als geeignet bewertet wird, wobei eine Messposition als geeignet bewertet wird, wenn die Ungenauigkeit bei der Bestimmung der Position und/oder Orientierung des Messgerätes verringert wird.

Zu Beginn des erfindungsgemäßen Verfahrens wird ein Wahrscheinlichkeitsraster für die Position und/oder Orientierung des Messgerätes in der Messumgebung initialisiert, wobei die Wahrscheinlichkeit gleichverteilt ist, d.h. alle Positionen und/oder Orientierungen in der Messumgebung weisen die gleiche Wahrscheinlichkeit auf. Das Wahrscheinlichkeitsraster für die Position und/oder Orientierung des Messgerätes in der Messumgebung wird während des erfindungsgemäßen Verfahrens mithilfe von Messwerten, die das Messgerät bestimmt, aktualisiert.

Das erfindungsgemäße Verfahren umfasst eine Folge von vier Schritten, die wiederholt ausgeführt werden, bis es zum Abbruch der Folge kommt. In einem ersten Schritt der Folge wird die Notwendigkeit einer weiteren Messung durch das Messgerät und die Eignung der aktuellen Messposition des Messgerätes durch Anwendung des trainierten künstlichen neuronalen Netzes bewertet, wobei die Bewertung in Form eines Erfüllungsgrades für die Aktionen der Gruppe von Aktionen durchgeführt wird. In einem zweiten Schritt der Folge wird diejenige Aktion, für die im ersten Schritt der beste Erfüllungsgrad bestimmt wurde, als beste Aktion ermittelt und in einem dritten Schritt der Folge wird geprüft, ob die beste Aktion mit der Aktion "Abbrechen" übereinstimmt. Der weitere Ablauf ist vom Ergebnis der Überprüfung im dritten Schritt abhängig. Für den Fall, dass die beste Aktion mit der Aktion "Abbrechen" übereinstimmt, wird die Folge von Schritten abgebrochen und das erfindungsgemäße Verfahren mit der Berechnung der Position und/oder Orientierung des Messgerätes in der Messumgebung fortgesetzt und beendet. Für den Fall, dass die beste Aktion nicht mit der Aktion "Abbrechen" übereinstimmt, wird die Folge von Schritten mit einem vierten Schritt fortgesetzt wird. Im vierten Schritt der Folge wird die beste Aktion ausgeführt, wobei für den Fall, dass die Aktion "Verstellen 1" als beste Aktion ermittelt wurde, das Messgerät in einer neuen vorbestimmten Messposition angeordnet wird und das Verfahren mit dem ersten Schritt der Folge fortgesetzt wird. Für den Fall, dass die Aktion "Messen 1" als beste Aktion ermittelt wurde, wird in der aktuellen Messposition eine Messung mittels des Messgerätes durchgeführt, das Wahrscheinlichkeitsraster für die Position und/oder Orientierung des Messgerätes wird in der Messumgebung aktualisiert und das Verfahren wird mit dem ersten Schritt der Folge fortgesetzt.

Bevorzugt wird die Position und/oder Orientierung des Messgerätes in der Messumgebung aus dem Wahrscheinlichkeitsraster berechnet. Wenn bei der Ausführung des erfindungsgemäßen Verfahrens die Aktion "Abbrechen" als beste Aktion ermittelt wird, ist keine weitere Messung durch das Messgerät erforderlich; die vom Messgerät ermittelten Messwerte reichen aus, um die Position und/oder Orientierung des Messgerätes mit der geforderten Genauigkeit zu bestimmen. Dabei wird die Position und/oder Orientierung des Messgerätes in der Messumgebung aus dem Wahrscheinlichkeitsraster berechnet.

Bevorzugt wurde das künstliche neuronale Netz dahingehend trainiert, die aktuelle Messposition des Messgerätes als geeignet zu bewerten, wenn die Ungenauigkeit bei der Bestimmung der Position und/oder Orientierung des Messgerätes verringert wird. Dieses Training führt dazu, dass das Messgerät nur eine Messung ausführt, wenn die Messposition geeignet ist. Da die Aktion "Messen 1" mehr Zeit beansprucht als die Aktion "Verstellen 1" wird die zum Bestimmen der Position und/oder Orientierung des Messgerätes notwendige Zeit reduziert.

Bevorzugt wurde das künstliche neuronale Netz dahingehend trainiert, die Notwendigkeit einer weiteren Messung durch das Messgerät zu verneinen, wenn die Ungenauigkeit bei der Bestimmung der Position und/oder Orientierung des Messgerätes einen vorgegebenen Wert unterschreitet. Dieses Training führt dazu, dass die Messung mit dem Messgerät im Rahmen des erfindungsgemäßen Verfahrens beendet wird, wenn die geforderte Genauigkeit für die Position und/oder Orientierung des Messgerätes in der Messumgebung erreicht ist.

Bevorzugt wird bei Ausführung der Aktion "Verstellen 1" in der aktuellen Messposition und/oder neuen vorbestimmten Messposition mittels einer Kameraeinrichtung mindestens ein Bild der Messumgebung aufgenommen. Die Bilder der Messumgebung werden gespeichert und bei der Aktualisierung des Wahrscheinlichkeitsrasters berücksichtigt.

In einer bevorzugten Weiterentwicklung des Verfahrens umfasst die Gruppe von Aktionen zusätzlich zur Aktion "Abbrechen", Aktion "Verstellen 1" und Aktion "Messen 1" eine Aktion "Verstellen 2", die von der Aktion "Verstellen 1" verschieden ist, und/oder eine Aktion "Messen 2", die von der Aktion "Messen 1" verschieden ist. Für sämtliche Aktionen der Gruppe von Aktionen wird bei der Ausführung des erfindungsgemäßen Verfahrens im ersten Schritt der Folge ein Erfüllungsgrad berechnet und die Aktion, für die der beste Erfüllungsgrad bestimmt wurde, wird als beste Aktion ermittelt und ausgeführt.

Besonders bevorzugt unterscheidet sich die Aktion "Verstellen 2" durch eine Verstellrichtung und/oder einen Verstellwinkel von der Aktion "Verstellen 1". Für die Aktionen "Verstellen 1" und "Verstellen 2" wird bei der Ausführung des erfindungsgemäßen Verfahrens ein Erfüllungsgrad berechnet.

Besonders bevorzugt unterscheidet sich die Aktion "Messen 2" durch eine Messzeit und/oder eine Messgenauigkeit von der Aktion "Messen 1". Für die Aktionen "Messen 1" und "Messen 2" wird bei der Ausführung des erfindungsgemäßen Verfahrens ein Erfüllungsgrad berechnet.

Die vorliegende Erfindung betrifft außerdem ein Verfahren zum Präzisieren einer Position und/oder Orientierung eines Messgerätes, wobei die Position und/oder Orientierung des Messgerätes mithilfe eines Verfahrens nach einem der Ansprüche 1 bis 8 bestimmt wurde. Die Position und/oder Orientierung des Messgerätes in der Messumgebung wird mithilfe des erfindungsgemäßen Verfahrens bestimmt, wobei diese Position und/oder Orientierung im Anschluss mithilfe bekannter Verfahren präzisiert werden kann.

Die vorliegende Erfindung betrifft außerdem eine Vorrichtung zum Bestimmen einer Position und/oder Orientierung eines Messgerätes mithilfe eines Verfahrens zum Bestimmen einer Position und/oder Orientierung nach einem der Ansprüche 1 bis 8. Die Vorrichtung umfasst neben dem Messgerät eine Kontrolleinrichtung, die über eine Kommunikationsverbindung mit dem Messgerät verbunden ist.

Die vorliegende Erfindung betrifft außerdem ein Computerprogrammprodukt, umfassend eine Folge von darauf gespeicherten Steuerbefehlen, die bei Ausführung durch eine Kontrolleinrichtung ein Messgerät zur Durchführung eines Verfahrens nach einem der Ansprüche 1 bis 8 veranlasst. Das erfindungsgemäße Verfahren wird von der Kontrolleinrichtung ausgeführt, die über eine Kommunikationsverbindung mit dem Messgerät verbunden ist.

### Ausführungsbeispiele

Ausführungsbeispiele der Erfindung werden nachfolgend anhand der Zeichnung beschrieben. Diese soll die Ausführungsbeispiele nicht notwendigerweise maßstäblich darstellen, vielmehr ist die Zeichnung, wo zur Erläuterung dienlich, in schematischer und/oder leicht verzerrter Form ausgeführt. Dabei ist zu berücksichtigen, dass vielfältige Modifikationen und Änderungen betreffend die Form und das Detail einer Ausführungsform vorgenommen werden können, ohne von der allgemeinen Idee der Erfindung abzuweichen. Die allgemeine Idee der Erfindung ist nicht beschränkt auf die exakte Form oder das Detail der im Folgenden gezeigten und beschriebenen bevorzugten Ausführungsform oder beschränkt auf einen Gegenstand, der eingeschränkt wäre im Vergleich zu dem in den Ansprüchen beanspruchten Gegenstand. Bei gegebenen Bemessungsbereichen sollen auch innerhalb der genannten Grenzen liegende Werte als Grenzwerte offenbart und beliebig einsetzbar und beanspruchbar sein. Der Einfachheit halber sind nachfolgend für identische oder ähnliche Teile oder Teile mit identischer oder ähnlicher Funktion gleiche Bezugszeichen verwendet.

Es zeigen:
- FIG. 1: eine Vorrichtung mit einem Messgerät, dessen Position und/oder Orientierung in einer Messumgebung mithilfe eines erfindungsgemäßen Verfahrens bestimmt werden soll;
- FIG. 2: das erfindungsgemäße Verfahren zum Bestimmen der Position und/oder Orientierung des Messgerätes der FIG. 1 in einer Messumgebung in Form eines Ablaufdiagramms;
- FIG. 3: ein Wahrscheinlichkeitsraster für drei verschiedene Orientierungen zu Beginn des erfindungsgemäßen Verfahrens;
- FIG. 4: ein Wahrscheinlichkeitsraster für drei verschiedene Orientierungen während der Ausführung des erfindungsgemäßen Verfahrens; und
- FIG. 5: ein Wahrscheinlichkeitsraster für drei verschiedene Orientierungen am Ende des erfindungsgemäßen Verfahrens.

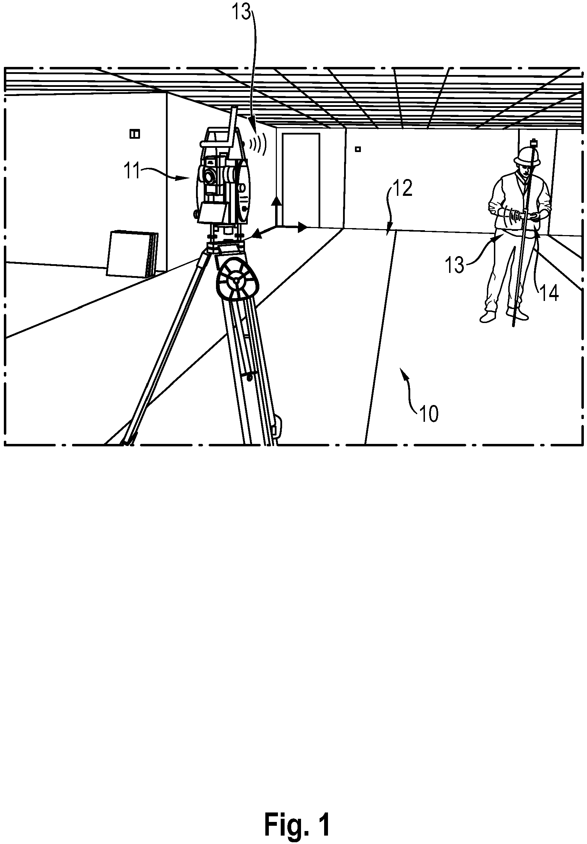

**FIG. 1** zeigt eine Vorrichtung **10** mit einem Messgerät **11,** dessen Position und/oder Orientierung in einer Messumgebung **12** mithilfe eines erfindungsgemäßen Verfahrens bestimmt werden soll. Unter dem Begriff "Messgerät" werden sämtliche Geräte zusammengefasst, die für die Durchführung von Messaufgaben vorgesehen sind. Das Messgerät 11, das im Ausführungsbeispiel als Totalstation ausgebildet ist, ist über eine Kommunikationsverbindung **13** mit einer Kontrolleinrichtung **14** verbunden. Die Steuerung des erfindungsgemäßen Verfahrens erfolgt über die Kontrolleinrichtung 14.

Die Messumgebung 12 ist in einem Geometriemodell abgebildet. Als Geometriemodell kann ein mit CAD-Unterstützung hergestelltes Konstruktionsmodell der Messumgebung 12 verwendet werden. Alternativ kann die Messumgebung 12 mithilfe eines Laserscanners abgescannt werden und aus den Scandaten ein Geometriemodell der Messumgebung 12 erstellt werden. Das Geometriemodell kann die Messumgebung 12 vollständig oder nur teilweise abbilden. Für die vorliegende Anmeldung sind die Oberflächen der Messumgebung 12 maßgeblich, die als Reflektionsfläche oder Streufläche für eine Distanzmessung verwendet werden.

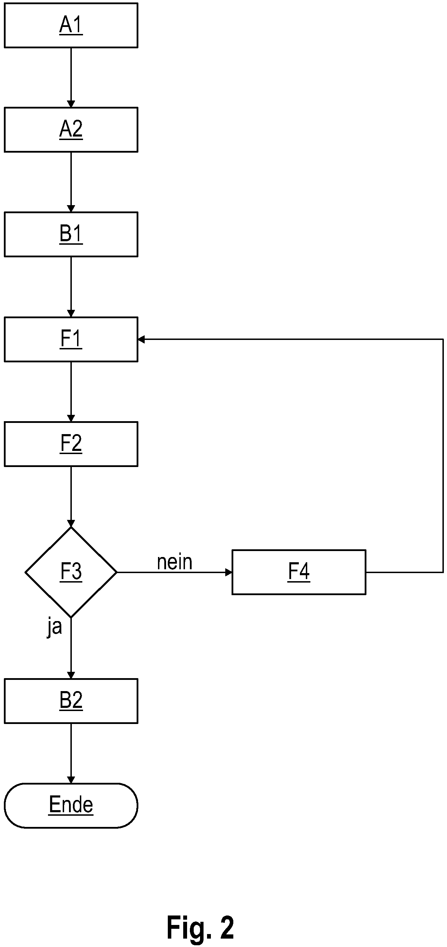

**FIG. 2** zeigt das erfindungsgemäße Verfahren zum Bestimmen der Position und/oder Orientierung des Messgerätes 10 der FIG. 1 in einer Messumgebung in Form eines Ablaufdiagramms. Das Verfahren wird anhand der in FIG. 1 gezeigten Vorrichtung 10 mit dem Messgerät 11 und der Kontrolleinrichtung 13 beschrieben.

Die Idee des erfindungsgemäßen Verfahrens besteht darin, die Position und/oder Orientierung des Messgerätes 11 in der Messumgebung 12 mithilfe eines trainierten künstlichen neuronalen Netzes zu bestimmen. Dazu wird in einem Schritt **A1** ein künstliches neuronales Netz mittels bekannter Messumgebungen dahingehend trainiert, dass eine Prognose für die Notwendigkeit einer weiteren Messung durch das Messgerät 11 und für die Eignung einer Messposition des Messgerätes 11 abgegeben werden kann. Jede Messumgebung, die zum Training des künstlichen neuronalen Netzes verwendet wird, ist durch ein Geometriemodell definiert und wird in mehreren Bildern abgebildet.

Die Aktionen, die das Messgerät 11 während des erfindungsgemäßen Verfahrens ausführen kann, werden in einem Schritt **A2** in einer Gruppe von Aktionen festgelegt, die zumindest eine Aktion "Abbrechen", eine Aktion "Verstellen 1" und eine Aktion "Messen 1" umfasst. Die Aktion "Abbrechen" bedeutet, dass keine weitere Messung durch das Messgerät 11 erforderlich ist und die vom Messgerät 11 ermittelten Messwerte ausreichen, um die Position und/oder Orientierung des Messgerätes 11 in der Messumgebung 12 mit der geforderten Genauigkeit zu bestimmen. Dabei bedeutet die Aktion "Verstellen 1", dass eine weitere Messung durch das Messgerät 11 erforderlich ist und die aktuelle Messposition des Messgerätes 11 als nicht geeignet bewertet wird und die Aktion "Messen 1", dass eine weitere Messung durch das Messgerät 11 erforderlich ist und die aktuelle Messposition des Messgerätes 11 als geeignet bewertet wird. Eine Messposition wird als geeignet bewertet, wenn die Ungenauigkeit bei der Bestimmung der Position und/oder Orientierung des Messgerätes 11 verringert wird.

Das erfindungsgemäße Verfahren umfasst eine Folge von Schritten **F1, F2, F3** und **F4,** die wiederholt ausgeführt werden, bis es zum Abbruch der Folge kommt. Im ersten Schritt F1 der Folge wird die Notwendigkeit einer weiteren Messung durch das Messgerät 11 und die Eignung der aktuellen Messposition des Messgerätes 11 durch Anwendung des trainierten künstlichen neuronalen Netzes bewertet, wobei die Bewertung in Form eines Erfüllungsgrades für die Aktionen der Gruppe von Aktionen durchgeführt wird. Im zweiten Schritt F2 der Folge wird diejenige Aktion, für die im ersten Schritt der beste Erfüllungsgrad bestimmt wurde, als beste Aktion ermittelt und im dritten Schritt F3 der Folge wird geprüft, ob die beste Aktion mit der Aktion "Abbrechen" übereinstimmt.

Der weitere Ablauf des erfindungsgemäßen Verfahrens ist vom Ergebnis der Überprüfung im dritten Schritt F3 abhängig. Für den Fall, dass die beste Aktion mit der Aktion "Abbrechen" übereinstimmt (ja in Schritt F3), wird die Folge von Schritten abgebrochen und das erfindungsgemäße Verfahren wird mit der Berechnung der Position und/oder Orientierung des Messgerätes 11 in der Messumgebung 12 in einem Schritt **B2** fortgesetzt und nach Schritt B2 beendet. Für den Fall, dass die beste Aktion nicht mit der Aktion "Abbrechen" übereinstimmt (nein in Schritt F3), wird die Folge von Schritten mit dem vierten Schritt F4 fortgesetzt wird. Im vierten Schritt F4 der Folge wird die beste Aktion ausgeführt, wobei für den Fall, dass die Aktion "Verstellen 1" als beste Aktion ermittelt wurde, das Messgerät 11 in einer neuen vorbestimmten Messposition angeordnet und das erfindungsgemäße Verfahren mit dem ersten Schritt F1 der Folge fortgesetzt wird. Für den Fall, dass die Aktion "Messen 1" als beste Aktion ermittelt wurde, wird in der aktuellen Messposition eine Messung mittels des Messgerätes 11 durchgeführt, das Wahrscheinlichkeitsraster für die Position und/oder Orientierung des Messgerätes 11 in der Messumgebung wird aktualisiert und das Verfahren wird mit dem ersten Schritt F1 der Folge fortgesetzt.

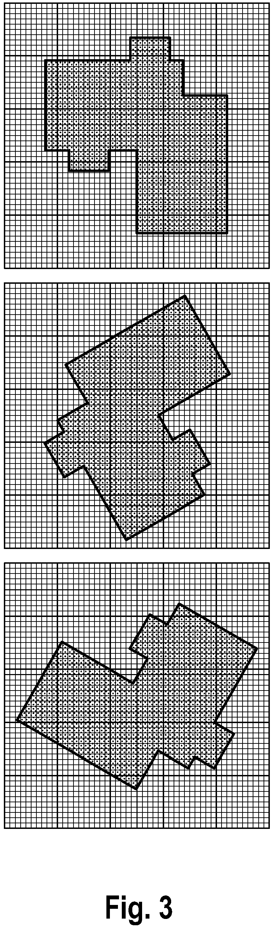

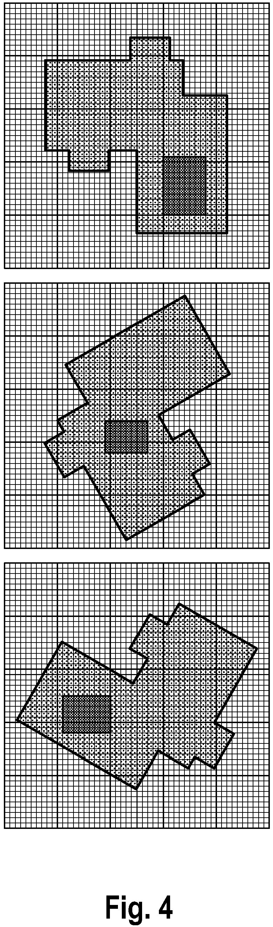

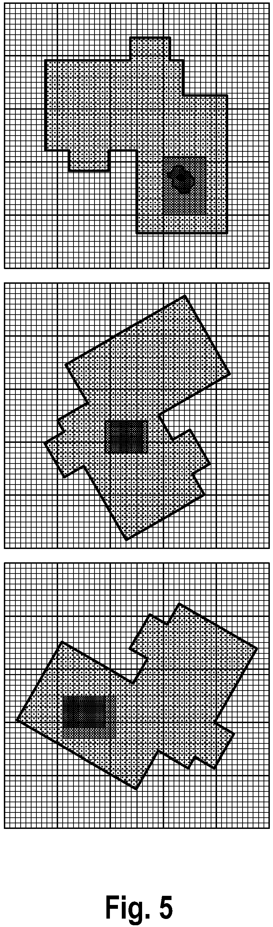

Im Rahmen des erfindungsgemäßen Verfahrens wird die Position und/oder Orientierung des Messgerätes 11 in der Messumgebung 12 aus einem Wahrscheinlichkeitsraster berechnet. Im Wahrscheinlichkeitsraster wird für die Messumgebung 12, in der die Position und/oder Orientierung des Messgerätes 12 bestimmt werden soll, die Wahrscheinlichkeitsverteilung abgebildet. **FIG. 3** zeigt das Wahrscheinlichkeitsraster für drei verschiedene Orientierungen zu Beginn des erfindungsgemäßen Verfahrens, **FIG. 4** zeigt das Wahrscheinlichkeitsraster für drei verschiedene Orientierungen während der Ausführung des erfindungsgemäßen Verfahrens und **FIG. 5** zeigt das Wahrscheinlichkeitsraster für drei verschiedene Orientierungen am Ende des erfindungsgemäßen Verfahrens.

Zu Beginn des erfindungsgemäßen Verfahrens wird das Wahrscheinlichkeitsraster für die Position und/oder Orientierung des Messgerätes 11 in der Messumgebung 12 initialisiert, wobei die Wahrscheinlichkeit gleichverteilt ist, d.h. alle Positionen und Orientierungen in der Messumgebung weisen die gleiche Wahrscheinlichkeit auf (FIG. 3). Während der Ausführung des erfindungsgemäßen Verfahrens wird die Folge von Schritten F1, F2, F3 und F4 wiederholt ausgeführt; die im vierten Schritt bestimmten Messwerte werden dazu genutzt, das Wahrscheinlichkeitsraster zu aktualisieren (FIG. 4). Die Folge von Schritten F1, F2, F3 und F4 wird abgebrochen, wenn im dritten Schritt F3 die beste Aktion mit der Aktion "Abbrechen" übereinstimmt, und das erfindungsgemäße Verfahren wird mit der Berechnung der Position und/oder Orientierung des Messgerätes 11 in der Messumgebung 12 beendet; die Position und/oder Orientierung des Messgerätes 11 wird aus dem Wahrscheinlichkeitsraster bestimmt (FIG. 5).

## Patentansprüche

1. Verfahren zum Bestimmen einer Position und/oder Orientierung eines Messgerätes (11) in einer Messumgebung (12), die in einem Geometriemodell abgebildet ist, mit den Schritten:
▪ Bereitstellen eines trainierten künstlichen neuronalen Netzes, das mittels bekannter Messumgebungen dahingehend trainiert wurde, eine Prognose für die Notwendigkeit einer weiteren Messung durch das Messgerät (11) und ggfs. eine Prognose für die Eignung einer Messposition des Messgerätes (11) abzugeben,
▪ Festlegen einer Gruppe von Aktionen, die zumindest eine Aktion "Abbrechen", eine Aktion "Verstellen 1" und eine Aktion "Messen 1" umfasst, wobei die Aktion "Abbrechen" bedeutet, dass keine weitere Messung durch das Messgerät (11) erforderlich ist, die Aktion "Verstellen 1" bedeutet, dass eine weitere Messung durch das Messgerät (11) erforderlich ist und die aktuelle Messposition des Messgerätes (11) als nicht geeignet bewertet wird, und die Aktion "Messen 1" bedeutet, dass eine weitere Messung durch das Messgerät (11) erforderlich ist und die aktuelle Messposition des Messgerätes (11) als geeignet bewertet wird,
▪ Initialisieren eines Wahrscheinlichkeitsrasters für die Position und/oder Orientierung des Messgerätes (11) in der Messumgebung (12),
▪ Ausführen einer Folge von Schritten, wobei
(1) in einem ersten Schritt der Folge die Notwendigkeit einer weiteren Messung durch das Messgerät (11) und die Eignung der aktuellen Messposition des Messgerätes (11) durch Anwendung des trainierten künstlichen neuronalen Netzes bewertet wird, wobei die Bewertung in Form eines Erfüllungsgrades für die Aktionen der Gruppe von Aktionen durchgeführt wird,
(2) in einem zweiten Schritt der Folge diejenige Aktion, für die im ersten Schritt der beste Erfüllungsgrad bestimmt wurde, als beste Aktion ermittelt wird,
(3) in einem dritten Schritt der Folge geprüft wird, ob die beste Aktion mit der Aktion "Abbrechen" übereinstimmt, wobei
- für den Fall, dass die beste Aktion nicht mit der Aktion "Abbrechen" übereinstimmt, die Folge von Schritten fortgesetzt wird, und
- für den Fall, dass die beste Aktion mit der Aktion "Abbrechen" übereinstimmt, die Folge von Schritten abgebrochen wird,
(4) in einem vierten Schritt der Folge die beste Aktion ausgeführt wird, wobei
- für den Fall, dass die Aktion "Verstellen 1" als beste Aktion ermittelt wurde, das Messgerät (11) in einer neuen Messposition angeordnet wird und das Verfahren mit dem ersten Schritt der Folge fortgesetzt wird, und
- für den Fall, dass die Aktion "Messen 1" als beste Aktion ermittelt wurde, in der aktuellen Messposition eine Messung mittels des Messgerätes (11) durchgeführt wird, das Wahrscheinlichkeitsraster für die Position und/oder Orientierung des Messgerätes (11) in der Messumgebung (12) aktualisiert wird und das Verfahren mit dem ersten Schritt der Folge fortgesetzt wird,
▪ Fortsetzung des Verfahrens nach Abbruch der Folge im dritten Schritt mit der Berechnung der Position und/oder Orientierung des Messgerätes (11) in der Messumgebung (12).

2. Verfahren nach Anspruch 1, **dadurch gekennzeichnet, dass** die Position und/oder Orientierung des Messgerätes (11) in der Messumgebung (12) aus dem Wahrscheinlichkeitsraster berechnet wird.

3. Verfahren nach einem der Ansprüche 1 bis 2, **dadurch gekennzeichnet, dass** das künstliche neuronale Netz dahingehend trainiert wurde, die aktuelle Messposition des Messgerätes (11) als geeignet zu bewerten, wenn die Ungenauigkeit bei der Bestimmung der Position und/oder Orientierung des Messgerätes (11) verringert wird.

4. Verfahren nach einem der Ansprüche 1 bis 3, **dadurch gekennzeichnet, dass** das künstliche neuronale Netz dahingehend trainiert wurde, die Notwendigkeit einer weiteren Messung durch das Messgerät (11) zu verneinen, wenn die Ungenauigkeit bei der Bestimmung der Position und/oder Orientierung des Messgerätes (11) einen vorgegebenen Wert unterschreitet.

5. Verfahren nach Anspruch 1, **dadurch gekennzeichnet, dass** bei Ausführung der Aktion "Verstellen 1" in der alten Messposition und/oder neuen Messposition mittels einer Kameraeinrichtung mindestens ein Bild der Messumgebung (12) aufgenommen wird.

6. Verfahren nach einem der Ansprüche 1 bis 5, **dadurch gekennzeichnet, dass** die Gruppe von Aktionen zusätzlich zur Aktion "Abbrechen", Aktion "Verstellen 1" und Aktion "Messen 1" eine Aktion "Verstellen 2", die von der Aktion "Verstellen 1" verschieden ist, und/oder eine Aktion "Messen 2", die von der Aktion "Messen 1" verschieden ist, umfasst.

7. Verfahren nach Anspruch 6, **dadurch gekennzeichnet, dass** sich die Aktion "Verstellen 2" durch eine Verstellrichtung und/oder einen Verstellwinkel von der Aktion "Verstellen 1" unterscheidet.

8. Verfahren nach Anspruch 6, **dadurch gekennzeichnet, dass** sich die Aktion "Messen 2" durch eine Messzeit und/oder eine Messgenauigkeit von der Aktion "Messen 1" unterscheidet.

9. Verfahren zum Präzisieren einer Position und/oder Orientierung eines Messgerätes (11), wobei die Position und/oder Orientierung des Messgerätes (11) mithilfe eines Verfahrens zum Bestimmen einer Position und/oder Orientierung nach einem der Ansprüche 1 bis 8 bestimmt wurde.

10. Vorrichtung (10) zum Bestimmen einer Position und/oder Orientierung eines Messgerätes (11) in einer Messumgebung (12) mithilfe eines Verfahrens zum Bestimmen einer Position und/oder Orientierung nach einem der Ansprüche 1 bis 8.

11. Computerprogrammprodukt, umfassend eine Folge von darauf gespeicherten Steuerbefehlen, die bei Ausführung durch eine Kontrolleinrichtung (14) ein Messgerät (11) zur Durchführung eines Verfahrens zum Bestimmen einer Position und/oder Orientierung nach einem der Ansprüche 1 bis 8 veranlasst.
